# EUROPEAN PATENT SPECIFICATION

(11) **EP 1 965 618 B1**
(45) Date of publication and mention of the grant of the patent: **14.11.2012**
(21) Application number: 06834682.4
(22) Date of filing: 14.12.2006
(51) Int. Cl.: H05K 3/26, B08B 3/08, C11D 7/18, C11D 7/32, C11D 7/60, H01L 21/304

(54) **COMPOSITION FOR REMOVING RESIDUE FROM WIRING BOARD AND CLEANING METHOD**
ZUSAMMENSETZUNG ZUR ENTFERNUNG VON RÜCKSTÄNDEN VON EINER LEITERPLATTE UND REINIGUNGSVERFAHREN
COMPOSITION POUR ENLEVER LES RÉSIDUS SUR DES GRILLES DE CONNEXIONS ET PROCÉDÉ DE NETTOYAGE

(30) Priority: 20.12.2005 JP 2005365729
(43) Date of publication of application: 03.09.2008
(73) Proprietor: MITSUBISHI GAS CHEMICAL COMPANY, INC., Chiyoda-ku, Tokyo 100-8324 (JP)
(72) Inventor: KUWABARA, Eiko c/o Mitsubishi Gas Chemical Company, Inc., Katsushika-ku, Tokyo 1250051 (JP); KASHIWAGI, Hideo c/o Mitsubishi Gas Chemical Company, Inc., Katsushika-ku, Tokyo 1250051 (JP); MATSUNAGA, Hiroshi c/o Mitsubishi Gas Chemical Company, Inc., Katsushika-ku, Tokyo 1250051 (JP); OHTO, Masaru c/o Mitsubishi Gas Chemical Company, Inc., Katsushika-ku, Tokyo 1250051 (JP)
(74) Representative: Gille Hrabal
(86) International application number: PCT/JP2006/324928
(87) International publication number: WO 2007/072727

(56) References cited:
- EP-A1- 1 211 563
- EP-A2- 1 331 287
- JP-A- 2005 181 910
- JP-A- 2005 292 288
- JP-A- 2005 333 104
- US-A1- 2004 224 866

## Description

### Technical Field

The present invention relates to a composition for removing a residue to be used for manufacturing a wiring board of a semiconductor integrated circuit, a liquid crystal panel, an organic electroluminescence (hereinafter abbreviated as "EL") panel, a printed board or the like and a cleaning method and in detail, to a composition for removing a residue from a wiring board containing titanium or a titanium alloy and a cleaning method.

### Background art

In a manufacturing step of a wiring board of a semiconductor integrated circuit, a liquid crystal panel, an organic EL panel, a printed board or the like, in fabricating a circuit on the board surface, a wiring is fabricated by coating a resist and a photomask on the board surface, developing the resist and then performing a dry etching step. A residue derived from the resist or a residue derived from members used in the integrated circuit is deposited on a pattern side part or a bottom part after the dry etching step, and therefore, the removal of this reside is necessary.

As a method for removing this residue deposited on the board after the drying etching step, a wet process is studied, and for example, there are proposed a method for using a removing composition composed of hydroxylamine, an alcoholamine and a gallic acid compound (Patent Document 1), a method for using a resist removing composition composed of a fluorine compound and an organic solvent (Patent Document 2), a method for using a resist removing composition composed of hydrogen peroxide, a quaternary ammonium salt and an anticorrosive (Patent Document 3) and a method for using a resist removing composition composed of hydrogen peroxide ammonium sulfate, a fluorine compound and a chelating agent (Patent Document 4).
Compositions containing hydrogen peroxide and an azole compound are described in EP 1 331 287 A2 and US 2004/0224866 A1.

These resist removing compositions to be used in the residue removal step by a wet process are required to have low corrosiveness against wiring materials such as copper, aluminum, titanium and alloys thereof, insulating film materials and diffusion-preventing film materials. In particular, following the miniaturization of a semiconductor integrated circuit or the like in recent years, a tolerable level of corrosiveness has become extremely severe.
However, the foregoing methods by a wet process are large in corrosiveness against titanium or titanium alloys and hardly applicable to the residue removal step in the manufacture of a wiring board using titanium or a titanium alloy.

Patent Document 1: JP-A-9-296200
Patent Document 2: JP-A-11-67632
Patent Document 3: JP-A-2002-202617
Patent Document 4: JP-A-2004-325918

### Disclosure of the Invention

### Problems that the Invention is to Solve

An object of the present invention is to provide a composition for removing a residue, which in manufacturing a wiring board, is able to effectively remove residues remaining after dry etching which are derived from a resist or metals without corroding titanium or titanium alloys with high corrosiveness and a cleaning method.

### Means for Solving the Problems

The present inventors made extensive and intensive investigations regarding the foregoing problems. As a result, it has been found that a composition containing hydrogen peroxide, a chelating stabilizer and an azole compound and having a pH of from 1 to 7 is able to effectively remove a resist residue or a residue derived from a metal which is a wiring material such as copper, aluminum and titanium after dry etching without corroding titanium or titanium alloys, leading to accomplishment of the present invention.

Specifically, the present invention provides:
1. A composition for removing a residue from a wiring board comprising hydrogen peroxide, an azole compound and a chelating stabilizer, wherein the chelating stabilize is selected from the group consisting of aminotri(methylenephosphonic acid), 1-hydroxyethylidene-1,1-diphosphonic acid, ethylenediaminetetra(methylenephosphonic acid), diethylenetriaminepenta(methylenephosphonic acid) and ethylenediamine, and the composition has a pH of from 2 to 6.
2. The composition for removing a residue from a wiring board as set forth above in 1, wherein the azole compound is a triazole compound and/or a tetrazole compound.
3. The composition for removing a residue from a wiring board as set forth above in 1 or 2, wherein the concentration of the azole compound is from 0.0001 to 5 % by mass.
4. The composition for removing a residue from a wiring as set forth above in any one of 1 to 3, wherein the concentration of hydrogen peroxide is from 0.01 to 20 % by mass.
5. The composition for removing a residue from a wiring board as set forth above in any one of 1 to 4, wherein the concentration of the chelating stabilizer is from 0.0001 to 0.1 % by mass.
6. A cleaning method of a wiring board comprising removing a residue from a wiring board after dry etching by using the composition for removing a residue from a wiring board as set forth above in any one of 1 to 5.
7. The cleaning method of a wiring board as set forth above in 6, wherein the wiring board contains titanium and/or a titanium alloy.

### Advantages of the Invention

By using the composition for removing a residue from a wiring board according to the present invention, residues remaining after dry etching which are derived from a resist or metals such as copper, aluminum and titanium in a wiring board of a semiconductor integrated circuit, a liquid crystal panel, an organic EL panel, a printed board or the like, especially a titanium-containing wiring board can be effectively removed without corroding titanium or titanium alloys; and a semiconductor device using such a wiring board can be efficiently manufactured.

### Brief Description of the Drawings

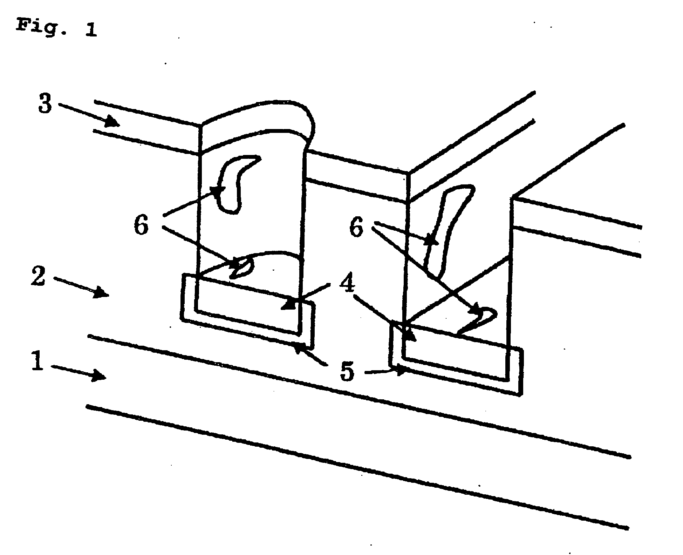

Fig. 1 is a cross-sectional view of a silicon wafer board used in the Examples and Comparative Examples, in which a via structure and a trench structure are prepared by an etching treatment. In the drawing, though a via and a trench are precisely prepared on copper wirings, in fact, there may be the case where the via or trench deviates. In that case, a titanium portion is exposed.

### Description of Reference Numerals and Signs

1: Silicon substrate, 2: Carbon-doped silicon oxide, 3: Resist, 4: Copper, 5: Titanium, 6: Dry etching residue

### Best Modes for Carrying Out the Invention

The present invention is hereunder described in detail.
According to the invention hydrogen peroxide is used as the oxidizing agent, and the concentration of hydrogen peroxide in the cleaning liquid is preferably from 0.01 % by mass to 20 % by mass, more preferably from 0.05 % by mass to 5 % by mass, and especially preferably from 0.1% by mass to 3 % by mass. When the concentration of hydrogen peroxide is 0.01 % by mass or more, the residue removal properties are enhanced, and when it is not more than 20 % by mass, an increase of the solubility of titanium is avoided.

Examples of the azole compound which is used in the composition for removing a residue of the present invention include imidazole, pyrazole, thiazole, isoxazole, benzotriazole, 1H-1,2,3-triazole, 1H-1,2,4-triazole, 1H-tetrazole, 1-methylimidazole, benzimidazole, 3-methylpyrazole, 4-methylpyrazole, 3,5-dimethylpyrazole, 3-aminopyrazole, 3-amino-5-methylpyrazole, 4-methylthiazole, 5-methylisoxazole, 3-amino-5-methylisoxazole, 2-aminothiazole, 1,2,3-triazole-4,5-dicarboxylic acid, 3,5-di-amino-1,2,4-triazole, 3-amino-1,2,4-triazole, 1H-4,5-methylbenzotriazole, 2-(3,5-di-t-butyl-2-hydr-oxyphenyl)benzotriazole and 5-amino-1H-tetrazole. Above all, triazole compounds or tetrazole compounds are favorable, and 5-amino-1H-tetrazole, benzotriazole, 1H-1,2,4-triazole and 3,5-diamino-1,2,4-triazole are more preferable. These azole compounds are an anticorrosive of titanium or titanium alloys and can be used singly or in admixture.

In the composition for removing a resin of the present invention, in addition to the foregoing azole compound, pyrroles, pyridines, quinolines, morpholines and the like may be used in combination as the anticorrosive.
Examples of the pyrroles include pyrrole, 2H-pyrrole, 1-methylpyrrole, 2-ethylpyrrole, 2,4-dimethylpyrrole, 2, 5-dimethylpyrrole and 1, 2, 5-trimethylpyrrole. Examples of the pyridines include pyridine, 2-picoline, 3-picoline, 4-picoline, 2-ethylpyridine, 3-ethylpyridine, 4-methylpyridine, 2,3-lutidine, 2,4-lutidine, 3,5-lutidine, 4-t-butylpyridine, 2-aminopyridine, 3-aminopyridine and 4-aminopyridine. Examples of the quinolines include quinoline, isoquinoline, quinaldine, 3-methylquinoline, 2-hydroxyquinoline, 3-hydroxyquinoline, 5-hydroxyquinoline, 3-aminoquinoline, 5-aminoquinoline, 8-aminoquinoline, 5-nitroquinoline, 6-nitroquinoline, 8-nitroquinoline, 8-methyl-5-nitroquinoline and 8-hydroxy-5-nitroquinoline. Examples of the morpholines include morpholine, 1-methylmorpholine, 1-ethylmorpholine, hydroxyethylmorpholine, hydroxypropylmorpholine, aminoethylmorpholine and aminopropylmorpholine.

The concentration of the azole compound which is used in the composition for removing a residue of the present invention is preferably from 0.0001 % by mass to 5 % by mass, more preferably 0.01 % by mass to 3 % by mass, and especially preferably from 0.1 % by mass to 1 % by mass. When the concentration of the azole compound is 0.0001% by mass or more, an anticorrosion effect against titanium or titanium alloys is obtained, and from the viewpoints of economy and practicality, the concentration of the azole compound is preferably not more than 5 % by mass.

Since hydrogen peroxide is instable against metals, the composition for removing a residue of the present invention contains a stabilizer of hydrogen peroxide.
The stabilizer of hydrogen peroxide is a chelating stabilizer selected from aminotri(methylenephosphonic acid), 1-hydroxyethylidene-1,1-diphosphonic acid, ethylenediaminetetra(methylenephosphonic acid), diethylenetriaminepenta(methylenephosphonic acid) and ethylenediamine. In the present invention, these stabilizers can be used without particular limitations. The concentration of the stabilizer is preferably 0.0001 % by mass to 0.1 % by mass. When the concentration of the stabilizer is 0.0001 % by mass or more, an effect for stabilizing hydrogen peroxide is obtained, and from the viewpoints of economy and practicality, the concentration of the stabilizer is preferably not more than 0.1 % by mass.

The pH of the composition for removing a residue of the present invention is from 2 to 6. When the pH is 1 or more, the residue removal properties are enhanced, and when the pH is not more than 7, the dissolution of titanium or titanium alloys is suppressed. A substance which is used for adjusting the pH is not particularly limited, and general acids including inorganic acids such as sulfuric acid, phosphoric acid and hydrochloric acid and organic acids such as formic acid and acetic acid can be used.

By using the composition for removing a residue of the present invention singly in a step of removing a residue after dry etching in a semiconductor manufacturing apparatus, a residue derived from a resist on a wiring board of a semiconductor integrated circuit, a liquid crystal panel, an organic EL panel, a printed board or the like and a residue derived from a metal which is a wiring material such as copper, aluminum and titanium after the dry etching step can be effectively removed.
Even when a wiring board is treated with other resist removing composition before and after treating the wiring board with the composition for removing a residue of the present invention, there is no problem at all. On that occasion, though known resist removing compositions can be used, an organic alkaline composition is especially favorable.

Examples of the wiring board which is used in the cleaning method of the invention include semiconductor boards using a semiconductor wiring material (for example, silicon, amorphous silicon, polysilicon, silicon oxide, silicon nitride, copper, titanium, titanium nitride, titanium-tungsten, tungsten, tantalum, tantalum alloys, cobalt, cobalt alloys, chromium, chromium oxide and chromium alloys) or a compound semiconductor (for example, gallium-arsenic, gallium-phosphorus and indium-phosphorus); printed boards such as polyimide resins; and glass boards to be used in LCD or the like. These wiring boards are not corroded with the composition for removing a residue of the present invention.

### Examples

The present invention is hereunder more specifically described with reference to the following Examples and Comparative Examples. However, it should be construed that the present invention is not at all limited to these Examples.
In the following Examples and Comparative Examples, the measurement and evaluation methods of the composition for removing a residue are as follows.

### 1. Preparation of specimen A:

On a silicon wafer substrate in which a wiring layer composed of copper and titanium and an insulating layer composed of carbon-doped silicon oxide were stacked, a resist pattern was formed, and dry etching was performed using this resist pattern as a mask to form a pattern composed of copper, titanium and carbon-doped silicon oxide, thereby obtaining a specimen A. A schematic view of a cross-section of the specimen A is shown in Fig. 1.

### 2. Measurement of titanium dissolution rate (Ti E/R):

The composition for removing a residue was heated at 40 °C; a silicon wafer having a 1, 000 angstrom-thick titanium film (1 angström = 10⁻¹⁰ m) prepared on the surface thereof was dipped therein for a prescribed time and then rinsed with ultra pure water; and a difference in thickness of the titanium film before and after the treatment was measured by a fluorescent X-ray unit. The dipping time of the wafer was adjusted to a degree that the titanium film did not disappear. A titanium dissolution rate (Ti E/R) per minute was calculated from the obtained difference in film thickness.

### 3. Evaluation of corrosiveness of wiring layer and residue removal properties:

The specimen A was subjected to a dipping treatment with the composition for removing a residue at 40 °C for 3 minutes, rinsed with ultra pure water and then blow dried by a nitrogen gas, and the presence or absence of corrosion of the wiring layer and the presence or absence of a residue were confirmed through observation by a scanning electron microscope (SEM) .
The corrosiveness of wiring layer and the residue removal properties were evaluated as follows.

### (Corrosiveness of wiring layer)

○: Corrosion of the wiring layer is not observed at all.
Δ: Corrosion of the wiring layer is partially observed.
×: Corrosion of the wiring layer is entirely observed.

### (Residue removal properties)

○: Remaining of a residue is not observed at all.
Δ: Remaining of a residue is partially observed.
×: Remaining of a residue is entirely observed.

### Examples 1 to 4

Compositions for removing a residue as shown in Table 1 were prepared and measured for the titanium dissolution rate and evaluated for the corrosiveness of wiring layer and the residue removal properties relative to the specimen A.
In Tables 1 and 2, DTPP expresses diethylenetriaminepenta(methylenephosphonic acid). Also, all of concentrations (%) shown in the composition in the tables are % by mass, and the remainders not reaching 100 % by mass are all water.
In these Examples, the residue could be removed without causing corrosion of the wiring layer, and the dissolution of titanium could be suppressed.

**[Table 1]**

| | Composition | | pH | Ti E/R [angstrom/min] | Corrosiveness of wiring layer | Residue removal properties |
|---|---|---|---|---|---|---|
| | Compound | Concentration | | | | |
| Example 1 | Hydrogen peroxide | 3% | 4.7 | 1.2 | ○ | ○ |
| | Benzotriazole | 0.1 % | | | | |
| | DTPP | 1 ppm | | | | |
| Example 2 | Hydrogen peroxide | 3 % | 2 | 0.8 | ○ | ○ |
| | Sulfuric acid | 0.05 % | | | | |
| | 5-Amino-1H-tetrazole | 0.5 % | | | | |
| | DTPP | 1 ppm | | | | |
| Example 3 | Hydrogen peroxide | 3 % | 5.9 | 1 | ○ | ○ |
| | 1,2,4-Triazole | 1 % | | | | |
| | DTPP | 1 ppm | | | | |
| Example 4 | Hydrogen peroxide | 1 % | 5.9 | 0.3 | ○ | ○ |
| | 1,2,4-Triazole | 1 % | | | | |
| | DTPP | 1 ppm | | | | |

### Comparative Examples 1 to 9

Compositions for removing a residue as shown in Table 2 were prepared and measured for the titanium dissolution rate and evaluated for the corrosiveness of wiring layer and the residue removal properties relative to the specimen A. Also, the titanium dissolution rate (Ti E/R) was measured.

**[Table 2]**

| | Composition | | pH | Ti E/R [angstrom/min] | Corrosive ness of wiring layer | Residue removal properties |
|---|---|---|---|---|---|---|
| | Compound | Concentration | | | | |
| Comparative Example 1 | Hydrogen peroxide | 3 % | 5.2 | 10 | × | ○ |
| | DTPP | 1 ppm | | | | |
| Comparative Example 2 | Hydrogen peroxide | 15 % | 4.1 | 25 | × | ○ |
| | DTPP | 1 ppm | | | | |
| Comparative Example 3 Example 3 | Hydrogen peroxide | 15 % | 3 | 46 | × | ○ |
| | Sulfuric acid | 0.4 % | | | | |
| | DTPP | 1 ppm | | | | |
| Comparative Example 4 | Hydrogen peroxide | 3 % | 8 | 2.9 | Δ | ○ |
| | 1,2,4-Triazole | 1 % | | | | |
| | Tetrabutylammonium hydroxide | 0.25% | | | | |
| | DTPP | 1 ppm | | | | |
| Comparative Example 5 | Hydrogen peroxide | 3 % | 6.5 | 5.2 | × | ○ |
| | Ammonium acetate | 2 % | | | | |
| Comparative Example 6 | Hydrogen peroxide | 3 % | 3.5 | 14 | × | ○ |
| | Ammonium sulfate | 5 % | | | | |
| | Ammonium hexafluorosilicate | 0.5 % | | | | |
| | Ethylene glycol | 5 % | | | | |
| Comparative Example 7 | Hydrogen peroxide | 3 % | 0.8 | 26 | × | ○ |
| | Sulfuric acid | 10 % | | | | |
| | Acetic acid | 2 % | | | | |
| | Ammonium fluoride | 0.05 % | | | | |
| Comparative Example 8 | Ammonium fluoride | 1 % | 9.6 | 1.7 | Δ | Δ |
| | Dimethylformamide | 70 % | | | | |
| Comparative Example 9 | Hydroxylamine | 35 % | 12 | < 0.1 | × | ○ |
| | Ethanolamine | 60 % | | | | |
| | Gallic acid | 5 % | | | | |

In Comparative Examples 1 to 7, the titanium dissolution rate was large, and the corrosion of the wiring was observed. Also, in Comparative Examples 8 and 9, though the titanium dissolution rate was small, the corrosion of the wiring was observed.

### Industrial Applicability

By using the composition for removing a residue of the present invention, in manufacturing a wiring board, residues remaining after dry etching which are derived from a resist or metals can be effectively removed without corroding titanium or titanium alloys with high corrosiveness, and in particular, a semiconductor device using a wiring board containing titanium or titanium alloys can be efficiently manufactured.

## Claims

1. A composition for removing a residue from a wiring board comprising hydrogen peroxide, an azole compound and a chelating stabilizer, wherein the chelating stabilizer is selected from the group consisting of aminotri(methylenephosphonic acid), 1-hydroxyethylidene-1,1-diphosphonic acid, ethylenediaminetetra(methylenephosphonic acid), diethylenetriaminepenta(methylenephosphonic acid) and ethylenediamine, and the composition has a pH of from 2 to 6.

2. The composition for removing a residue from a wiring board according to claim 1, wherein the azole compound is a triazole compound and/or a tetrazole compound.

3. The composition for removing a residue from a wiring board according to claim 1 or 2, wherein the concentration of the azole compound is from 0.0001 to 5 % by mass.

4. The composition for removing a residue from a wiring board according to any one of claims 1 to 3, wherein the concentration of hydrogen peroxide is from 0.01 to 20 % by mass.

5. The composition for removing a residue from a wiring board according to any one of claims 1 to 4, wherein the concentration of the chelating stabilizer is from 0.0001 to 0.1 % by mass.

6. A cleaning method of a wiring board comprising removing a residue from a wiring board after dry etching by using the composition for removing a residue from a wiring board according to any one of claims 1 to 5.

7. The cleaning method of a wiring board according to claim 6, wherein the wiring board contains titanium and/or a titanium alloy.

## Patentansprüche

1. Zusammensetzung zur Entfernung von Resten von einher Leiterplatte, enthaltend Wasserstoffperoxid, eine Azol-Verbindung und einen chelatbildenden Stabilisator, worin der chelatbildende Stabilisator ausgewählt ist aus der Gruppe bestehen aus Aminotri(methy)enphosphonsäure), 1-Hydroxyethyliden-1,1-diphosphonsäure, Ethylendiaminotetra(methy)enphosphonsäure), Diethylentriaminopenta(methylenphosphonsäure) und Ethylendiamin und wobei die Zusammensetzung einen pH-Wert von 2 bis 6 aufweist.

2. Zusammensetzung zur Entfernung von Resten von einer Leiterplatte gesäß Aspruch 1, worin die Azol-Verbindung eine Thiazol-Verbindung und/oder eine Tetrazol-Verbindung ist.

3. Zuaammensetzung zur Entfernung vorn Resten von einer Leiterplatte gemäß Anspruch 1 oder 2, worin die Konzentration der Azol-Verbindung 0,0001 bis 5 Massen-% beträgt.

4. Zusammensetzung zur Entfernung von Resten von einer Leiterplatte gemäß einem der Anspruche 1 bits 3, worin die Konzentration von Wasserstoffperoxid 0,01 bis 20 Massen-% beträgt.

5. Zusammensetzung zur Entfernung von Resten von einer Leiterplatte gesäß einem der Ansprüche 1 bis 4, worin die Konzentration des chelatbildenden Stabilisators 0,0001 bis 0,1 massen-% beträgt.

6. Reinigungsverfahren für eine Leiterplatte, umfassend das entfernen eines Restes von der Leiterplatte nach Trockenätzen unter Verwindung der Zusammensetzung zur Entfernung von Resten von einer Leiterplatte gemäß einem der Ansprüche 1 bis 5.

7. Reinigungsverfahren für eine Leiterplatte gemäß Anspruch 6, worin die Leiterplatte Titan und/oder eine Titanlegierung enthält.

## Revendications

1. Compositions pour éliminer un résidu d'une carte de câblage comprenant du d'hydrogène, un composé azole et un stabilisateur chélatant, dans laquelle le stabilisateur chélatant est sélectionné parmi le groupe consistant en de l'acide aminotri(méthylénephosphonique), de l'acide 1-hydroxyéthylidène-1,1-diphosphonique, de l'acide éthylènediaminetétra(méthy)ènephosphonique), de l'acide diéthylènetriaminepenta(méthylènephosphonique et de l'éthylènediamine et la composition présente un pH de 2 à 6.

2. Composition pour éliminer un résidu d'une carte de câblage selon la revendication 1 , dans laquelle le composé azole est un composé thiazole et/ou un composé tetrazole.

3. Composition pour éliminer un résidu d'une carte de câblage selon l'une des revendications 1 ou 2, dans laquelle la concentration du composé azole est de 0,0001 à 5 % en masse.

4. Composition pour éliminer un résidu d'une capte de câblage selon l'une revendications 1 à 3, dans laquelle la concentration du d'hydrogène est de 0,01 à 20 % en masse.

5. Composition pour éliminer un résidu d'une carte de câblage selon l'une des revendications 1 à 4, dans laquelle la concentration du stabilisateur chélatant est de 0,0001 à 0,1 % en masse.

6. Procédé de nettoyage d'une carte de câblage comprenant l'élimination d'un résidu une carte de câblage après la gravure sèche par l'utilisation de la composition pour éliminer un résidu d'une carte de câblage selon l'une des revendications 1 à 5.

7. Procédé de nettoyage d'une carte de câblage selon la revendication 6, dans lequel la carte de câblage contient du titane et/ou un alliage de titane.
